Europäisches Patentamt

European Patent Office

Office européen des brevets

(11) Publication number: **0 265 149**
A2

(12) **EUROPEAN PATENT APPLICATION**

(21) Application number: **87309043.5**

(22) Date of filing: **13.10.87**

(51) Int. Cl.4: **H03M 13/12**

(30) Priority: **23.10.86 GB 8625417**

(43) Date of publication of application:
**27.04.88 Bulletin 88/17**

(84) Designated Contracting States:
**DE FR IT NL**

(71) Applicant: **PLESSEY OVERSEAS LIMITED**
**Vicarage Lane**
**Ilford Essex IGI 4AQ(GB)**

(72) Inventor: **Zhi Chun Zhu**
**21 Western Elms Avenue**
**Reading RG3 2AL(GB)**
Inventor: **Clark Adrian Percy Prof.**
**58 Main Street**
**Willoughby on the Wolds Leics LE12**
**6SZ(GB)**

(74) Representative: **Elliott, Frank Edward**
**The Plessey Company plc. Intellectual**
**Property Department Vicarage Lane**
**Ilford, Essex IG1 4AQ(GB)**

(54) **Decoding of convolutional encoded signals.**

(57) A novel method and apparatus for decoding convolutional coded data signals using near-maximum likelihood detection in which vectors (possible symbol sequences) are expanded to provide different numbers of new vectors in dependance upon cost thresholds. In the example given for 8psk rate 2/3 convolutionally-coded signals, two cost threshold levels are provided to give three threshold groups, vectors in the three groups being respectively expanded to give four, two and one further vectors with their associated costs.

*FIG.I.*

Xerox Copy Centre

## DECODING OF CONVOLUTIONAL ENCODED SIGNALS

The present invention relates to decoding of convolutional encoded signals and more particularly to a method of decoding such signals using near-maximum likelihood decoders.

It is known to enhance the performance of digital data transmission systems by using convolutional coders to form the symbols to be transmitted in respect of data input and using a corresponding transmitted signal. Convolutional codes are discussed in IEEE Transactions on Communications technology volume Com-19 No 5 of October 1971 at pages 751 to 772 in an article entitled "Convolutional Codes and Their Performance in Communication Systems" by Andrew J Viterbi.

One practical optimum decoder employs an algorithm now known as the "Viterbi" algorithm which uses structural and distance properties of convolutional codes to achieve maximum likelihood (or minimum distance) decoding. The major problem with the Viterbi algorithm decoder is that for codes having large constraint lengths (e.g. greater than, say, ten symbols) the growth in equipment complexity makes such decoders impractical. Codes having large constraint lengths are, however, desirable since the tolerance of such codes to additive white Gaussian noise is better than for codes of short lengths resulting in lower error rates when optimum decoding is used.

Since it appears impractical to use Viterbi decoders with codes having a large constraint length, particularly due to the computation and storage requirements of such decoders, some detectors known as "near-maximum likelihood detectors" have been developed which approach maximum likelihood detection but have considerably lower storage and computation requirements.

Such a decoder assumes that the retained vectors will include the correct maximum likelihood sequence among the small number of vectors (typically four to sixteen) retained. It is here noted that the number of vectors is so limited to limit the number of computational operations necessarily performed on each date symbol.

Excessive transmissions noise levels may result in the correct vector being eliminated from those stored resulting in a (possible lengthy) sequence of incorrectly decoded signal (an error burst) before the decoder restores the desired maximum likelihood vector. Reducing the length of error bursts requires the retention of more vectors with the corresponding storage and computational penalties mentioned above.

It is an object of the present invention to provide a method of decoding convolutionally coded data signals using near-maximum likelihood detectors, the method providing improved noise tolerance compared to previous methods utilising a similar number of vectors.

According to the present invention there is provided a method of decoding convolutional-coded data signals comprising storing $m$ vectors and their associated costs, establishing $(n-1)$ cost thresholds (where $n$ is an integer of at least 2) dividing the $m$ vectors into $n$ threshold groups in dependance upon the value of the associated cost of each vector with respect to the $(n-1)$ cost thresholds and, on receipt of a further data symbol, expanding each of the $m$ vectors into $a$ times $p$ possible vectors, $p$ being an integer, the integer value of $a$ varying in dependance upon which of the $n$ groups the vector falls into, $a$ being greatest for vectors falling in the threshold group associated with the lowest cost threshold.

Preferably a vector falling in the threshold group associated with the highest cost threshold is expanded to form one new vector, the new vector being expanded by the symbol value giving the lowest associated cost.

A vector falling in the group associated with the lowest cost threshold may be expanded to provide a new vector in respect of each possible symbol value.

Vectors falling in groups intermediate those associated with the lowest and the highest cost values respectively may be expanded to form more than one new vector but less than the maximum possible number of new vectors, the expanding symbols for each new vector being selected to give lowest associated costs.

According to a feature of the present invention there is provided decoding apparatus for decoding convolutional-coded data signals using the method outlined in the preceding paragraph.

A decoding method in accordance with the invention and apparatus for performing the method will now be described by way of example only with reference to the accompanying drawings of which;

Figure 1 is a block schematic diagram of a transmission system model including a decoder using the method;

Figure 2 is a constellation map showing 8psk signalling used in the apparatus of Figure 1;

Figure 3 is a vector map showing the vector expansion arrangements; and,

Figures 4 to 6 are graphs showing a comparision between the performance of the decoder of Figure 1 and a Viterbi decoder when operated with various convolutional codes.

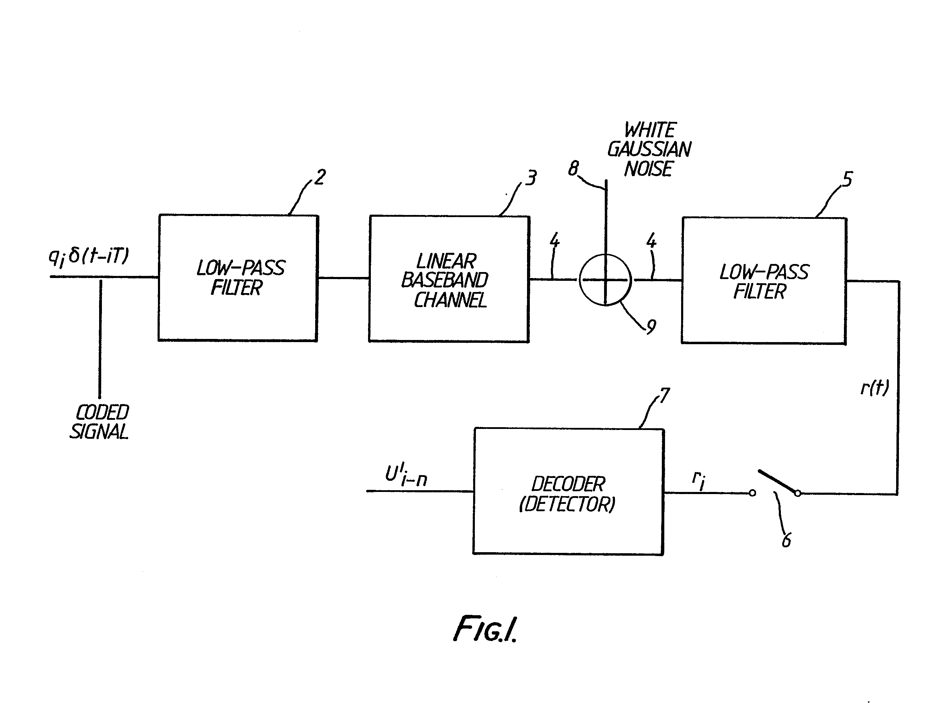

Referring first to figure 1, the data transmission system model shows that convolutionally coded input signals are affected by low pass filtering 2 and are transmitted in a linear baseband channel 3 on a transmission link 4 (the baseband channel and transmission link, for example, together forming a satellite radio link).

At the receiving end the transmitted signals are again submitted to low pass filtering 5 and are sampled at the symbol transmission rate by a switch 6 to provide input signal samples to a detector 7. The effect of noise on the channel 4 is indicated by a noise input 8 being applied to the channel 4 through an adder 9.

As thus far described the transmission system model is identical to many known system models which may use as the detector 7 a Viterbi detector or near-maximum likelihood detector. The present invention effects the computional and storage function of the decoder 7 and in order to simplify the description of the new decoding method consideration is now given to the data signals forwarded on the transmission channel 3 and 4.

The information to be transmitted is carried by a sequence of quaternary data symbols $\{s_i\}$, where $S_i$ is uniquely determined by a 2-component vector

$$U_i = [u_i^{(1)} \quad u_i^{(2)}] \qquad (1)$$

for $i \geq 0$. The components $u_i^{(1)}$ and $u_i^{(2)}$ of the vector $U_i$ are statistically independent binary numbers which are equally likely to have either value 0 or 1. Thus $U_i$ can have any of the four values, 00, 01, 10 and 11, the corresponding values of $s_i$ being -3, -1, 1 and 3, respectively. The sequence of the $\{U_i\}$ is fed to a rate-2/3 convolutional coder, and the corresponding coded symbol $q_i$, at time $t = iT$, is uniquely determined by a 3-component vector

$$V_i = [v_i^{(1)} \quad v_i^{(2)} \quad v_i^{(3)}] \qquad (2)$$

where $v_i^{(1)}$, $v_i^{(2)}$, and $v_i^{(3)}$ are independent binary numbers with possible values 0 and 1, so that $V_i$ can have 8 different possible values.

The rate-2/3 convolutional coder used here forms a sequence of coded vectors $\{V_i\}$ from the $\{U_i\}$, as follows. Let the three code generators of the code be the $(k_1 + k_2 + 2)$-components vectors

$$G^{(h)} = [G^{(1,h)} \quad G^{(2,h)}] \qquad (3)$$

for $h = 1,2,3$. Also let $G(1,h)$ and $G(2,h)$ be $(k_1 + 1)$-component and $(k_2 + 1)$-component vectors, respectively, where $k_1 < k_2$, and

$$G^{(1,h)} = [\, g_0^{(1,h)} \, g_1^{(1,h)} \, ... \, g_{K_1}^{(1,h)} \,] \qquad (4)$$

$$G^{(2,h)} = [\, g_0^{(2,h)} \, g_1^{(2,h)} \, ... \, g_{K_2}^{(2,h)} \,) \qquad (5)$$

The components $g_i^{(1,h)}$ and $g_i^{(2,h)}$ are binary numbers that can take on either value of 0 or 1. Therefore, the constraint length of the code is here given by $(k_2 + K_2 + 2)$ bits, which corresponds to a memory of $(k_1 + k_2)$ bits. Now,

$$v_i^{(h)} = \sum_{j=0}^{k_1} u_{i-j}^{(1)} g_j^{(1,h)} + \sum_{j=0}^{k_2} u_{i-j}^{(2)} g_j^{(2,h)} \qquad (6)$$

for $h = 1,2,3$, and modulo-2 addition is assumed.

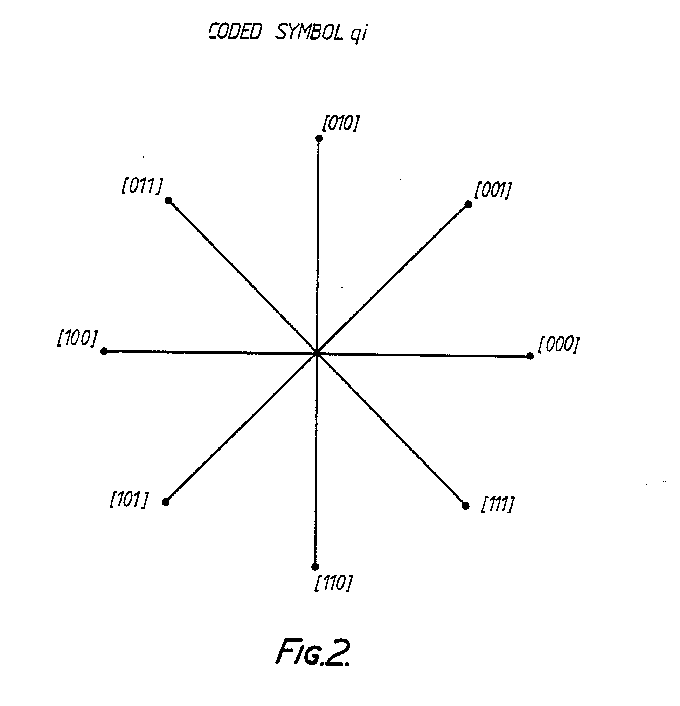

The 3-component vector $V_i$ is mapped on to the complex-number plate according to a given mapping function, to give the complex-valued symbol $q_i$. The mapping is one-to-one so that $q_i$ also has 8 different possible values the constellation being shown in Fig. 2. For a given $V_i$, the mapping function determines the phase $\phi_i$ of $q_i$ (in the complex-number plane) according to the equation

$$\phi_i = \frac{\pi}{4} [\, 4v_i^{(1)} + 2v_i^{(2)} + v_i^{(3)} \,] \qquad (7)$$

Now, $\qquad q_i = \cos\phi_i + j\sin\phi_i \qquad (8)$

where $j = \sqrt{-1}$, so that $q_i$ lies on the unit circle in the complex-number plane, and the average energy per symbol, defined as the mean-square value of $q_i$, is

$E_s = 1.0$

The corresponding transmitted signal element is $q_i \delta (t-iT)$, where $\delta (t-iT)$ is a unit impulse at time $t = iT$.

Three convolutional codes, with memories of 4, 5 and 6 bits, respectively, have been used for testing various decoders. The code generators of these codes being given in the following Table 1. (Overleaf).

| Code | Code memory in bits $k_1$ $k_2$ g | | | Number of states | Code generators $G(1,h)$ $G(2,h)$ | | Asymptotic coding gain relative to an QPSK signal (dB) |
|---|---|---|---|---|---|---|---|
| | | | | | 0 1 1 | 1 0 0 | |
| 1 | 2 | 2 | 4 | 16 | 1 0 0 | 0 0 1 | 4.1 |
| | | | | | 0 0 0 | 0 1 0 | |
| | | | | | 0 0 1 | 1 0 0 0 | |
| 2 | 2 | 3 | 5 | 32 | 1 0 0 | 0 0 1 1 | 4.6 |
| | | | | | 0 0 0 | 0 1 0 0 | |
| | | | | | 1 0 1 1 | 1 1 1 0 | |
| 3 | 3 | 3 | 6 | 64 | 1 0 1 0 | 0 0 0 1 | 5.0 |
| | | | | | 0 1 1 0 | 0 0 0 0 | |

Table 1: Rate 2/3 convolutional codes for 8PSK signals

Clearly, the coded symbol $q_i$ here carries two information bits and one redundant bit, thus the coded system has the same information rate as the corresponding uncoded system.

The sequence of impulses $\{q_i \delta (t-iT)\}$ is transmitted over the linear baseband channel 3 and 4, which includes a linear modulator (not shown) at the transmitter, a bandpass transmission path, and a linear coherent demodulator (not shown) at the receiver. The linear modulator is a combination of in-phase and quadrature suppressed carrier amplitude modulators, and the corresponding two input baseband modulating waveforms are appropriate shaped to give the required transmitted 8PSK signal. For testing purposes and the purposes of this description it is assumed that the only noise introduced in transmission is stationary white Gaussian noise, that is added to the transmitted signal waveform at the output of the channel 3 and 4. The resultant signal at the receiver is fed through the low-pass filter 5, and the received signal, after demodulation and sampling, is

$r_i = q_i + w_i$ (10)

where the real and imaginary parts of the noise components $\{w_i\}$ are statistically independant Gaussian random variables with zero mean and fixed variance $\sigma^2$. Correct carrier-phase and timing synchronisation is assumed at the receiver, the resultant filtering of the signal being such as to eliminate intersymbol interference.

The detector, shown in Figure. 1, operates directly on the sequence of received samples $\{r_i\}$. The corresponding output space sequence comprises the 2-components vectors $\{U'_i \}$, where

$U'_i = [ (u_i^{(1)})' \quad (u_i^{(2)})' ]$ (11)

and $(u_i^{(h)})' = 0$ or 1, for $h = 1$ and 2. In the absence of noice, $U'_i = U_i$, for each i. $U'_i$ uniquely

determines the detected data symbols $s'_i$ , whose possible values are -3, -1, 1 and 3, the relationship between $s'_i$ and $U'_i$ being the same as that between $s_i$ and $U_i$. Associated with any sequence of $\{U'_i\}$ is the corresponding sequence of complex-valued coded symbols $\{p_i\}$, where $p_i$ takes on a possible value of $q_i$ (eqns. 7 and 8 above). A maximum-likelihood decoder determines the sequence of $\{p_i$ that is at the minimum unitary distance from the sequence of received samples $\{r_i\}$. The sequence of $\{p_i\}$ then uniquely determines the corresponding sequence of $\{U'_i\}$ and hence the detected data symbols $\{s'_i\}$.

Consider a possible sequence of $\{U_i\}$ given by

$$Y_{i-1} = [X_0 \ X_1 \ ... \ X_{i-2} \ X_{i-1}] \qquad (12)$$

where $X_i$ represents a possible value of $U_i$ (Eqn. 1). Thus $X_i$ is a 2-component vector

$$X_i = [\ x_i^{(1)} \quad x_i^{(2)} \ ] \qquad (13)$$

where $x_i^{(1)}$ and $x_i^{(2)}$ are possible values of the components $u_i^{(1)}$ and $u_i^{(2)}$, respectively, of the vector $U_i$. Clearly $X_i$ can have any of the four values, 00, 01, 10 and 11.

The unitary distance squared between the sequence of received samples $\{r_i\}$ and the coded symbols $\{p_i\}$, corresponding to the vector $Y_{i-1}$, is given by the cost

$$C_{i-1} = \sum_{j=0}^{i-1} |r_j - p_j|^2 \qquad (14)$$

of the particular vector $Y_{i-1}$ . Thus

$$C_i = \sum_{j=0}^{i} |r_j - p_j|^2$$

$$= C_{i-1} + |r_i - p_i|^2 \qquad (15)$$

Theorectically, the final choice of the decoded message is not reached until the entire sequence $\{r_i\}$ has been received, but this usually means an unacceptable delay in detection. In practice, a delay of n symbols is introduced into the decoding process, where n is sufficiently large to avoid any significant increase in decoding errors due to early detection. Therefore, just prior to the receipt of the sample $r_i$, the detector holds a set of m different stored vectors $\{Z_{i-1}\}$, where $Z_{i-1}$ is formed by the last n components of the corresponding i-component vector $Y_{i-1}$ (eqn. 12) so that

$$Z_{i-1} = [\ X_{i-n} \ X_{i-n+1} \ ... \ X_{i-2} \ X_{i-1} \ ] \qquad (16)$$

bearing in mind that $X_i$ is a 2-component vector and is a possible value of $U_i$. The corresponding value of $C_{i-1}$ is now said to be the cost of the vector $Z_{i-1}$. In order to avoid an unacceptable increase in the costs, over a long message, the smallest cost $C_{i-1}$ is subtracted from each cost, before the decoder starts to operate on the received sample $r_i$. Thus the decoder reduces its smallest cost to zero without changing the difference between various costs.

In a first known near maximum likelihood detector, the decoder stores m different vectors $\{Z_{i-1}\}$ together with their associated cost $\{C_{i-1}\}$. On the receipt of the sample $r_i$, each vector $Z_{i-1}$ is expanded to form four vectors $\{P_i\}$ having four different possible values of $X_i$ , and the associated costs $\{C_i\}$ are calculated using eqn. 15 above. There are now 4m expanded vectors $\{p_i\}$ together with their cost $\{C_i\}$. The decoder selects the vector $p_i$ with the smallest cost $C_i$, and takes the first component $X_{i-n}$ of this vector as the decoded value $U'_{i-n}$ of $U_{i-n}$. All vectors $\{p_i$ for which $X_{i-n} \neq U'_{i-n}$ are then discarded, and the first components of all remaining vectors are omitted to give the corresponding n-component vectors $\{Z_i\}$. The decoder next selects the m vectors $\{Z_i$ with smallest costs $\{C_i\}$, and then substracts the smallest of these costs from each $C_i$. The decoder is now ready for the next received sample.

Clearly, for a given value of m, the decoder must evaluate 4m costs per decoded data symbol, and store m vectors. In practice, m is often much smaller than in the corresponding Viterbi decoder, leading to a reduction in equipment complexity.

A modified version of the system just discussed is now considered. The value of m here may change from the decoding of one received data symbol to another. The decoder uses two threshold levels, $d_1$ and $d_2$, where $0<d_1<d_2$, to eliminate the vectors with relatively large costs, and the optimum values of $d_1$ and $d_2$ are determined experimentally for any given code.

Just prior to the receipt of the sample $r_i$, the decoder holds in store m different vectors $\{Z_{i-1}$, together with their costs $\{C_{i-1}\}$, as before. However, only the vectors $\{Z_{i-1}\}$ for which $C_{i-1}<d_1$ have not been selected and stored in the decoding of the previous received sample $r_{i-1}$. The maximum permitted value of m, known as M, is selected to limit the maximum number of operations in the decoder. Thus the decoder selects up to M vectors with smallest costs in decoding each data symbol.

On receipt of the sample $r_i$, the decoder derives, from each vector $Z_{i-1}$ four vectors $\{p_i$ having four differenct possible values of $X_i$ and calculates the associated $\{C_i\}$ using eqn. 15. There are now 4m expanded vectors $\{p_i\}$ together with their costs $\{C_i\}$. The threshold level $d_2$ is then used to eliminate the vectors $\{p_i\}$ with relatively large costs. This is done by discarding any vector $p_i$ for which $C_i \geq d_2$. The decoder now selects the minimum cost vector from the remaining vectors $\{p_i\}$ and takes its first components $X_{i-n}$ as the decoded value $U^1_{i-n}$ of $U_{i-n}$, exactly as in the earlier known system. All vectors for which $X_{i-n} \neq U^1_{i-n}$ are then discarded, and the first components of the remaining vectors are also omitted to give the corresponding n-component vectors $\{Z_i\}$.

The selection of m stored vectors is achieved as follows. First, from the cost $\{C_i\}$ of the vectors $\{Z_i\}$ is subtracted the smallest cost, thus reducing the smallest cost zero. The decoder starts by selecting the zero cost vector, and then selects the vector with the second smallest cost, then the third, and so on, until either the vectors $\{Z_i\}$ for which $C_i<d_1$ have all been stored, or else m exceeds M. In the latter case, the M vectors $\{Z_i\}$ with the smallest costs $\{C_i\}$ are stored. The decoder is now ready for the next received sample.

In the method according to the invention a further modification to the second system described above is employed. In the system of the invention on receipt of $r_i$, each stored vector $Z_{i-1}$ is expanded to form $L_i$ vectors $\{p_i\}$, having different values of $X_i$, where $L_i$ takes on the value 4, 2, or 1, depending upon the cost $C_{i-1}$ of the corresponding vector $Z_{i-1}$. The value of $L_i$ is determined as follows.

$L_i = 4$ if $C_{i-1}<b_1$

$L_i = 2$ if $b_1 \leq C_{i-1}<b_2$

$L_i = 1$ if $b_2 \leq C_{i-1}$     (21)

where $b_1<b_2$, and the optimum values of the two positive constants $b_1$ and $b_2$ must be determined experimentally for any given code.

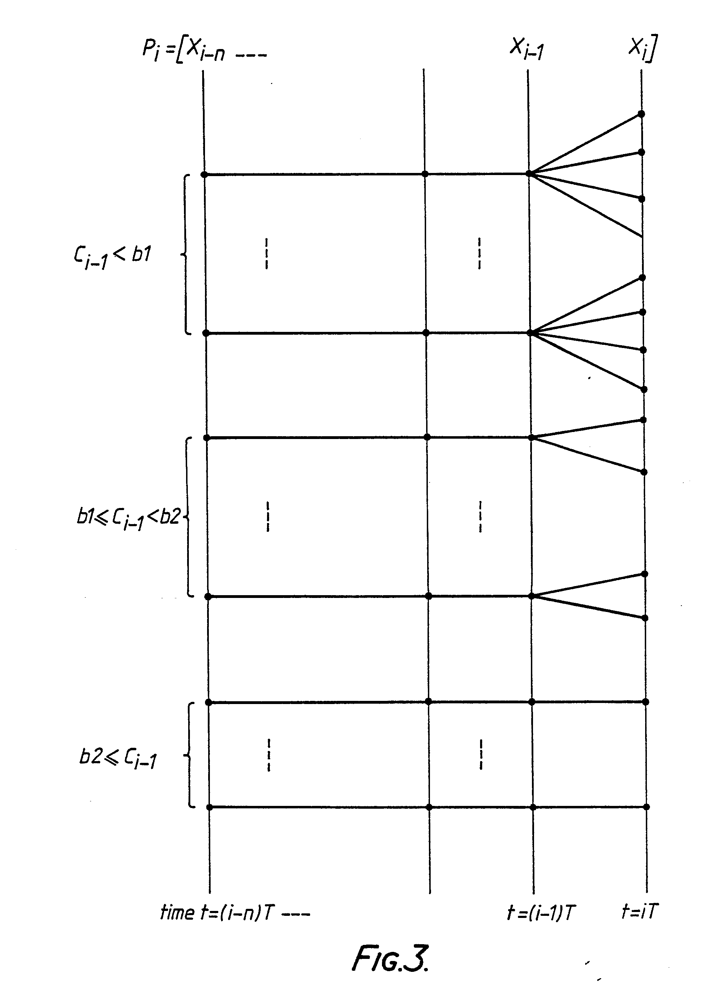

This process of adjustable expansion may be seen by reference to Fig. 3. The m stored vectors $\{Z_{i-1}\}$ are here placed in order of increasing cost, the cost of the first stored vector being zero. The vectors are classed into three groups, depending upon whether $C_{i-1}<b_1$, $b_1 \leq C_{i-1}<b_2$, or $b_2 \leq C_{i-1}$. On the receipt of the sample $r_i$, each vector $Z_{i-1}$ in the first group (for which $C_{i-1}<b_1$) is expanded to form four vectors $\{p_i\}$, having four different possible values of $X_i$, as before. The costs $\{C_i\}$ of these vectors $\{p_i\}$ are calculated using eqn. 15. Each vector $Z_{i-1}$ in the second group (for which $b_1 \leq C_{i-1}<b_2$) is expanded to form two vectors $\{p_i\}$, where the last components $\{X_i\}$ in the two vectors $\{p_i\}$, are those giving the smallest costs. Finally, each vector $Z_{i-1}$ in the third group (for which $b_2 \leq C_{i-1}$) is expanded to one vector $p_i$, whose last component $X_i$ takes on the one of its four possible values giving the smallest cost.

Since the costs $\{C_i\}$ of four different possible vectors $\{p_i\}$ originating from any given $Z_i$ differ only in the values $\{|r_i = p_i|^2$ (see eqn. 15), the vector $p_i$ having the smallest $C_i$ must also have the smallest $|r_i-p_i|^2$. Thus the value of $X_i$, for which $|r_i-p_i|^2$, and therefore the corresponding cost $C_i$, is smallest, can be determined from $r_i-p_i$ without actually calculating the four $\{C_i\}$. A further simplification is achieved as follows. For each stored vector $Z_{i-1}$ in the second group (for which $L_i = 2$), the first selected vector $p_i$ is determined as the vector for which

$d_a = |Re(r_i) = Re(p_i)| + |Im(r_i) - Im(p_i)|$     (22)

is minimum, over the four possible vectors $\{p_i\}$ originating from the given $Z_{i-1}$. $Re(.)$ and $Im(.)$ are then here the real and imaginary parts of the corresponding quantities. The second selected vector $p_i$ is that for which $d_a$ has its second smallest value. The two selected vectors $\{p_i\}$ are often (but not always) those with the smallest costs. Clearly, only the costs $\{C_i\}$ of the two selected vectors $\{p_i\}$ need be calculated. The process determines, for each stored vector $Z_{i-1}$ with $b_1 \leq C_{i-1}<b_2$, the two possible values of $X_i$ and hence the two expanded vectors $\{p_i\}$ that are worthy of further consideration by the decoder.

Similarly, each stored vector $Z_{i-1}$ in the third group is expanded to give the vector $p_i$, whose last component $X_i$ corresponds to the coded symbol $p_i$, for which $d_a$(eqn. 22) is minimum. Again, only the cost of the selected vector $p_i$ requires evaluation.

For a given value of m, the process results in the evaluation of $m_c$ costs together with the determination of $m_c$ expanded vectors $\{p_i\}$, where $m_c$ is less than 4m. The decoder now carries out the rest of the decoding process on the $m_c$ selected vectors $\{p_i\}$, using the two threshold levels $d_1$ and $d_2$, exactly as in the second system described above.

Having described the decoder of the invention, a comparsion of the decoder with a corresponding viterbi coder is now given. The important property of a decoder is its tolerance to additive white Gaussian noise. This is measured by the signal/noise ratio in the received samples $\{r_i\}$ for a given bit error rate in the decoded data symbols. Extensive computer simulation tests have therefore been carried out on the decoder described herein, to determine its relative tolerances to noise, when operating over the channel model described with reference to Figure 1. Decoders were tested with the three convolutional codes given in Table 1 above. The results of these tests are shown in Figs. 406, where the signal/noise ration, $\psi$ dB, is defined to be

$$\psi = 10 \log_{10} \left( \frac{E_s/2}{\sigma^2} \right)$$

$$= 10 \log_{10} \left( \frac{1}{2\sigma^2} \right) \tag{23}$$

The average transmitted energy per bit is $E_s/2$, where $E_s = 1.0$, and $\sigma^2$ is the variance and hense also the mean-square value of the real and imaginary parts of the Gaussian noise samples $\{w_i\}$ (eqn. 10). Perfect timing and carrier-phase synchronisation is assumed throughout, and 500,000 data symbols were transmitted for every different signal/noise ratio tested.

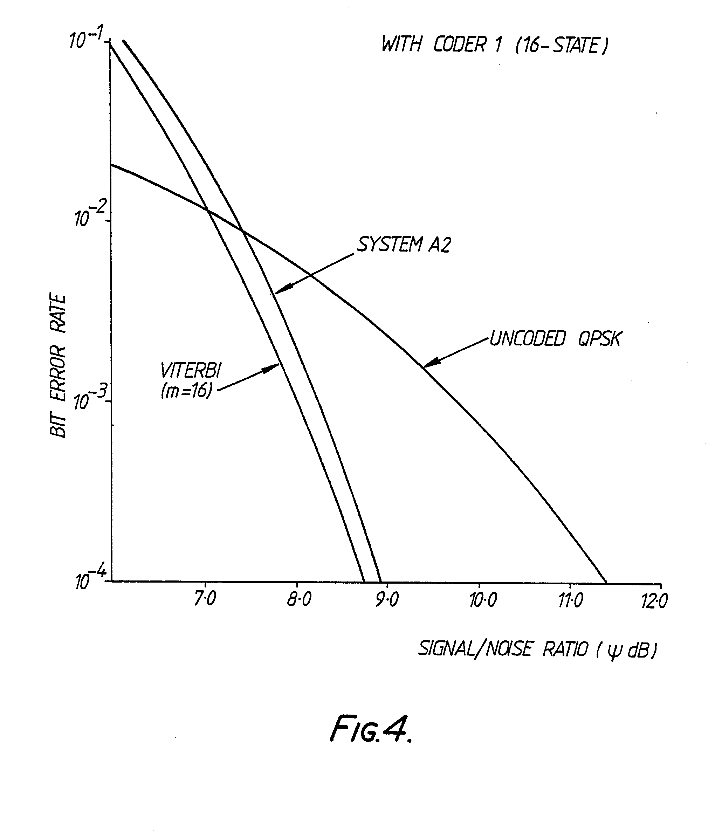

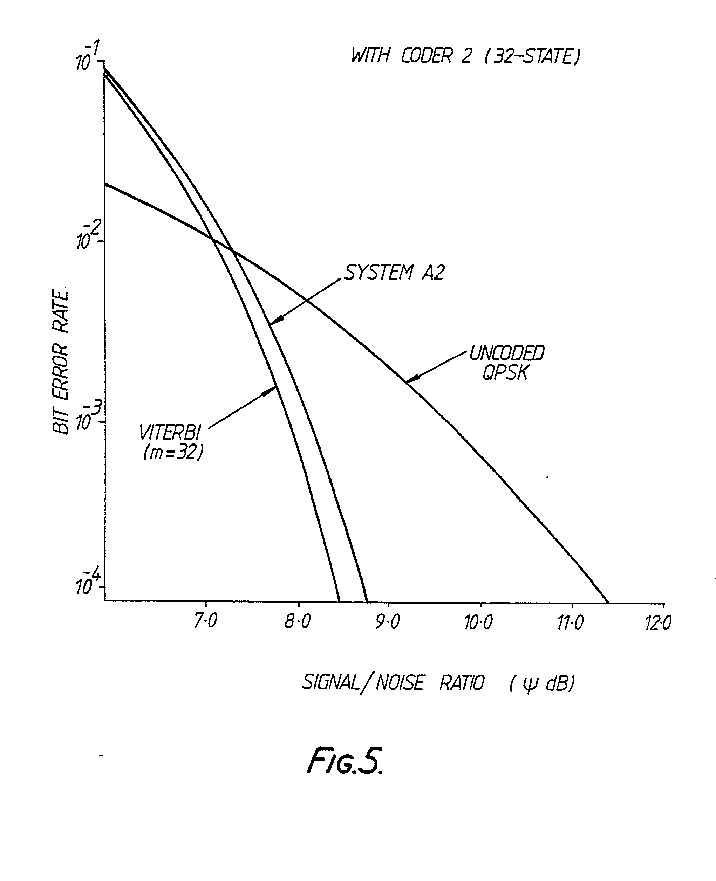

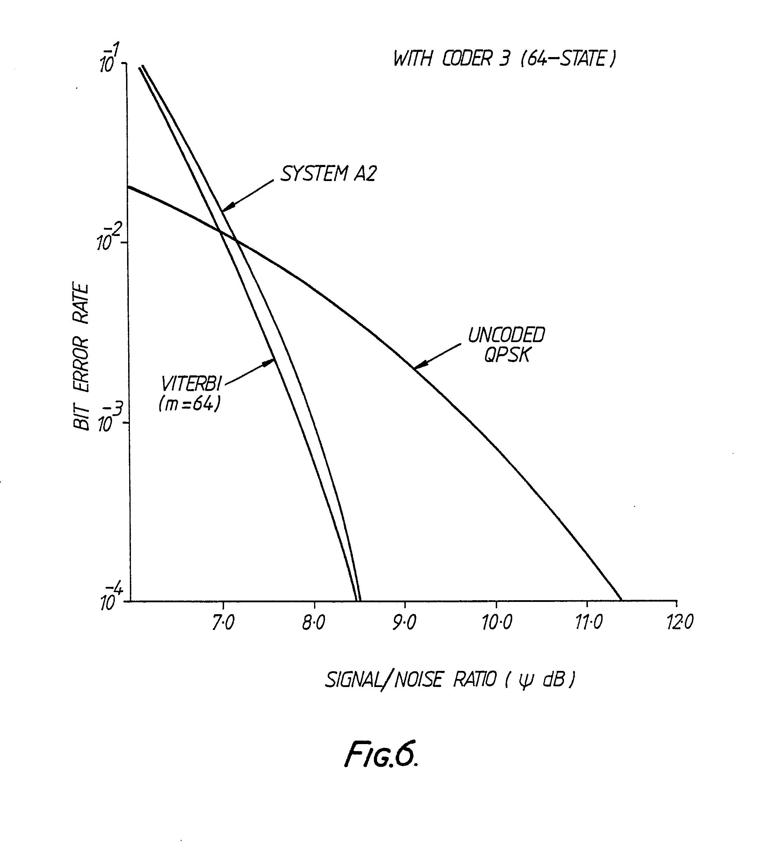

Figures 4 to 6 show the results of tests carried out with codes 1, 2 and 3 respectively compared with the performance of a corresponding Viterbi decoder and an uncoded QPSK system with coherent threshold detection. A more detailed comparison of the decoders is given in Table 2.

7

| Code | Decoder | Error rate $10^{-2}$ | | | Error rate $10^{-3}$ | | | Error rate $10^{-4}$ | | |
|---|---|---|---|---|---|---|---|---|---|---|
| | | $\bar{m}$ | $\bar{m}_C$ | signal/ noise ratio (dB) | $\bar{m}$ | $\bar{m}_C$ | signal/ noise ratio (dB) | $\bar{m}$ | $\bar{m}_C$ | signal/ noise ratio (dB) |
| 1 | Viterbi | 16 | 64 | 7.1 | 16 | 64 | 8.1 | 16 | 64 | 8.8 |
| | New Decoder | 6 | 13 | 7.4 | 4 | 8 | 8.2 | 3 | 7 | 8.9 |
| 2 | Viterbi | 32 | 128 | 7.2 | 32 | 128 | 7.9 | 32 | 128 | 8.5 |
| | New Decoder | 12 | 23 | 7.3 | 7 | 13 | 8.1 | 5 | 10 | 8.8 |
| 3 | Viterbi | 64 | 256 | 7.1 | 64 | 256 | 7.9 | 64 | 256 | 8.5 |
| | New Decoder | 18 | 34 | 7.2 | 10 | 20 | 8.0 | 8 | 15 | 8.5 |

Table 2: Signal/noise ratios, in dB, at error rates of $10^{-2}$, $10^{-3}$ and $10^{-4}$, for the different codes of table 1

The table here shows the signal/noise ratios in dB, for the different codes and decoders, together with the corresponding average number of stored vectors $\bar{m}$ and the average number of cost evaluations per decoded data symbol $\bar{m}$ for each system, at error rates of $10^{-2}$, $10^{-3}$ and $10^{-4}$. Tables 3.5 hereinafter are derived from Table 2, and show, at error rates of $10^{-2}$, $10^{-3}$ and $10^{-4}$, respectively, the relationship between the reduction in the value of $\bar{m}$, the reduction in the value of $\bar{m}_c$, and the relative tolerance to additive white Gaussian noise, when a near-maximum likelihood decoder in accordance with the invention is used in place of the Viterbi decoder.

In practice, the two threshold levels $d_1$ and $d_2$, and the quantity M, employed in the system A1 should be optimised for the most likely signal to noise ratio. Extensive computer simulation tests with different values of $d_1$, $d_2$ and M, have been carried out. The results show that, for the particular codes, with a memory of $(k_1 + k_2)$ bits, considered it is desirable that

$M < 2 \times 2^{k_1 + k_2}$ (24)

Also $d_1$ should lie in the range 1.4 to 1.8, and

$d_2 = d_1 + 0.5$ (25)

Appropriate values of $b_1$ and $b_2$ are 0.5 and 1.0 - 1.5, respectively. The results in Figs. 4-6, are those obtained with the most suitable values of $d_1$, $d_2$, M, $b_1$ and $b_2$.

These values are given in table 6.

| Decoder | m | n | $d_1$ | $d_2$ | M | $b_1$ | $b_2$ |
|---|---|---|---|---|---|---|---|
| Viterbi | 16 | 32 | – | – | – | – | – |
| New Decoder (Code 1) | – | 48 | 1.4 | 1.9 | 32 | 0.5 | 1.0 |
| Viterbi | 32 | 32 | – | – | – | – | – |
| New Decoder (Code 2) | – | 48 | 1.6 | 2.1 | 64 | 0.5 | 1.2 |
| Viterbi | 64 | 32 | – | – | – | – | – |
| New Decoder (Code 3) | – | 64 | 1.8 | 2.3 | 64 | 0.5 | 1.5 |

Table 6: Different system parameters for decoder compared with viterbi decoder.

As can be seen from Tables 2-5, if an appropriate arrangement of the system is used a further reduction of up to fifty percent in the average number of cost evaluations per decoded data symbol, can be achieved relative to the first of the two near-maximum likelihood detectors described here, with only a very small further degradation in performance. In other words, for a give amount of computation per decoded data symbol, the system can employ a significantly larger value of $\bar{m}$ and can therefore achieve a better tolerance to additive white Gaussian noise than previous systems.

The system may occasionally use a large number of vectors, which correspondingly increases the amount of computation per decoded data symbol over that period of time, however, at the most likely signal/noise ratios, the two decoders use only a small number of vectors for majority of the time. In order to exploit this property of the system, the computation involves in decoding any one received data symbol must not be confined to the corresponding sampling interval T. Instead, the time available for any one decoding process is variable, so that by spending less than T seconds on each of the majority of decoding processes, that require only a few vectors, considerably more than T seconds can be made available for each of the minority of decoding processes, that require a large number of vectors. For this to be possible two buffer stores are required, one to hold a number of received samples $\{r_i\}$ at the input to the decoder, and the other to hold a number of the decoded data-symbols $\{s_i'\}$ at the output of the decoder. While the decoder operates with only a few vectors, the input buffer store slowly empties while the output buffer store slowly fills, and while the decoder operates with a large number of vectors, the input buffer slowly fills while the output buffer store slowly empties.

Computer simulation tests have been carried out to determine the approximate size of each buffer store. It is assumed here that the time taken to decode any data symbol is determined by the total number of cost evaluations, $m_c$, involved in decoding that symbol. The results of the tests suggest that, if each buffer store can hold around 300 symbols (samples), then the value of $m_c$ that can be handled by the decoder, within the given sampling-interval T, must be not less than 1.5 $\bar{m}_c$ in order to reduce to a negligible value the probability that the input buffer store is filled. When the latter occurs, the maximum permitted member of expanded vectors (and hence cost evaluation) is reduced to a value of little below the number that can be handled within the sampling interval, and it is held at this value until the input buffer store is about two-thirds full. Normal operation of the system is then resumed.

It has, for example, been found that with code 3, for the system at an error rate of 1 in $10^3$, wherein $\bar{m}_c$ = 20 (Table 2), the coder must be able to process 32 expanded vectors within the sampling interval. However, no serious degradation in performance is likely to be experienced, if the storage capacity of each buffer store is reduced from 300 symbols (samples) to 200, with now the occasional reduction in the maximum permitted number of expanded vectors. Thus the size of the buffer stores and the resulting increase in the delay in detection need not be excessive.

Whilst as hereinbefore described the system has two threshold levels and uses expansion of four, two and one vectors for the three threshold groups it will be appreciated that more than two cost threshold levels my be used wih a variation in the number of vector expansion in intermediate threshold groups. Tables overleaf.

| | Number of stored vectors as a fraction of that in the corresponding Viterbi decoder | Number of cost evaluations per decoded data symbol as a fraction of that in the corresponding Viterbi decoder | Tolerance to noise relative to that of the corresponding Viterbi decoder (dB) |
|---|---|---|---|
| Viterbi | 1 | 1 | 0.0 |
| New Coder (Code 1) | 1/3 | 1/5 | −0.3 |
| | 1/2 | 1/4 | −0.3 |
| New Coder (Code 2) | 1/3 | 1/6 | −0.1 |
| | 1/2 | 1/5 | −0.1 |
| New Coder (Code 3) | 1/4 | 1/8 | −0.1 |
| | 1/3 | 1/7 | −0.1 |

Table 3: Relative complexities and performances of the different decoders at an error rate of $10^{-2}$

| | Number of stored vectors as a fraction of that in the corresponding Viterbi decoder | Number of cost evaluations per decoded data symbol as a fraction of that in the corresponding Viterbi decoder | Tolerance to noise relative to that of the corresponding Viterbi decoder (dB) |
|---|---|---|---|
| Viterbi | 1 | 1 | 0.0 |
| New Coder (Code 1) | 1/4 | 1/8 | −0.1 |
| New Coder (Code 2) | 1/5 | 1/10 | −0.2 |
| | 1/4 | 1/9 | −0.2 |
| New Coder (Code 3) | 1/7 | 1/13 | −0.1 |
| | 1/6 | 1/12 | −0.1 |

Table 4: Relative complexities and performances of the different decoders, at an error rate of $10^{-3}$

| | Number of stored vectors as a fraction of that in the corresponding Viterbi decoder | Number of cost evaluations per decoded data symbol as a fraction of that in the corresponding Viterbi decoder | Tolerance to noise relative to that of the corresponding Viterbi decoder (dB) |
|---|---|---|---|
| Viterbi | 1 | 1 | 0.0 |
| New Coder (Code 1) | 1/6 | 1/10 | −0.1 |
| | 1/5 | 1/9 | −0.1 |
| New Coder (Code 2) | 1/7 | 1/13 | −0.2 |
| | 1/6 | 1/12 | −0.2 |
| New Coder (Code 3) | 1/8 | 1/17 | 0.0 |

Table 5: Relative complexities and performances of the different decoders, at an error rate of $10^{-4}$

**Claims**

1. A method of decoding convolutional-coded data signals comprising storing $m$ vectors and their associated costs, establishing (n-1) cost threshold (where $n$ is an integer of at least 2) dividing the $m$ vectors into $n$ threshold groups in dependance upon the value of the associated cost of each vector with respect to the (n-1) cost threshold and, on receipt of a further data symbol, expanding each of the $m$ vectors into $a$ times $p$ possible vectors, $p$ being an integer the integer value of $a$ varying in dependance upon which of the $n$ groups the vector falls into, $a$ being greatest for vectors falling in the threshold group associated with the lowest cost threshold.

2. A method of decoding convolutional coded data signals as claimed in claim 1 in which a vector falling in the threshold group associated with the highest costs is expanded to form one new vector, the new vector being expanded by the symbol value giving the lowest associated cost.

3. A method of decoding convolutional coded data signals as claimed in claim 1 or claim 2 in which a vector falling in the threshold group associated with the lowest cost is expanded to provide a new vector in respect of each possible symbol value.

4. A method of decoding convolutional coded data signals as claimed in claim 1, claim 2 or claim 3 in which a vector falling in a threshold group intermediate the threshold groups associated with the lowest and the highest costs is expanded to form more than one new vectors but less than the maximum possible number of new vectors, the expanding symbols for each new vector being selected to give the lowest respective associated costs.

5. A method of decoding convolutional-coded data signals as claimed in any preceding claim wherein the cost of the vector associated with the lowest cost value is reduced to zero and a corresponding reduction in the cost is made to the costs of all of the other stored vectors.

6. A method of decoding convolutional coded data signals substantially as hereinbefore described with reference to the accompanying drawings.

7. Apparatus for decoding convolutional coded data signals comprising means to store $m$ vectors and their associated costs, comparision means for comparing the costs of the $m$ stored vectors with (n-1) cost threshold values to divide the $m$ vectors into $n$ threshold groups and means responsive to receipt of a further data symbol to expand each of the $m$ vectors into $a$ times $p$ possible vectos, in which the integer value of $a$ is varied in dependance upon which of the $n$ threshold groups the unexpanded vector falls within.

8. Apparatus for decoding convolutional coded data signals as claimed in claim 7 in which the value of $p$ varies in dependance upon costs associated with each of the vectors whereby in a signal having a high signal-to-noise ratio more vectors are expanded to increase the likelihood of the correct symbol sequence being determined.

9. Apparatus for decoding convolutional coded area signals as claimed in claim 8 comprising an input buffer store arranged to store data signal samples as received whereby when computation of a larger number of vectors requres a period in excess of the signal sampling period the buffer fills and, when computation of a smaller number of vectors is required, the buffer empties.

10. Apparatus for decoding convolutional coded data signals as claimed in claim 9 comprising means to restrict the value of $m$ if continuously low signal-to-noise ratio is likely to cause overflow of the input buffer store.

11. Apparatus for decoding convolutional coded data signals using the method substantially as hereinbefore described with reference to the accompanying drawings.

$$q_i \delta(t{-}iT)$$

CODED SIGNAL

LOW-PASS FILTER — 2

LINEAR BASEBAND CHANNEL — 3

WHITE GAUSSIAN NOISE — 8

LOW-PASS FILTER — 5

$r(t)$

DECODER (DETECTOR) — 7

$U^I_{i-n}$    $r_i$

FIG.I.

0 265 149

Neu eingereicht / Newly filed
Nouvellement déposé

Neu eingereicht / Newiy filed
Nouvellement déposé

CODED SYMBOL qi

*FIG.2.*

FIG.3.

WITH CODER 1 (16-STATE)

FIG.4.

Neu eingereicht / Newly filed
Nouvellement déposé

WITH CODER 2 (32-STATE)

BIT ERROR RATE.

SYSTEM A2

UNCODED QPSK

VITERBI (m=32)

SIGNAL/NOISE RATIO ( ψ dB)

FIG.5.

Neu eingereicht / Newly filed
Nouvellement déposé

WITH CODER 3 (64-STATE)

SYSTEM A2

UNCODED QPSK

VITERBI (m=64)

BIT ERROR RATE

SIGNAL/NOISE RATIO ( ψ dB )

FIG.6.